# EUROPEAN PATENT APPLICATION

(11) **EP 2 720 277 A1**
(43) Date of publication of application: **16.04.2014**
(21) Application number: 12797410.3
(22) Date of filing: 31.05.2012
(51) Int. Cl.: H01L 31/042

(54) **SOLAR CELL MODULE AND METHOD FOR MANUFACTURING SAME**

(30) Priority: 06.06.2011 JP 2011126467
(71) Applicant: Shin-Etsu Chemical Co., Ltd., Tokyo 100-0004 (JP)
(72) Inventor: FURIHATA Tomoyoshi, Annaka-shi Gunma 379-0195 (JP); ITO Atsuo, Annaka-shi Gunma 379-0195 (JP); KIM Hyung Bae, Annaka-shi Gunma 379-0195 (JP); IGARASHI Minoru, Annaka-shi Gunma 379-0224 (JP); HOTTA Masakatsu, Annaka-shi Gunma 379-0224 (JP); NAKAMURA Tsutomu, Annaka-shi Gunma 379-0224 (JP)
(74) Representative: Ter Meer Steinmeister & Partner
(86) International application number: PCT/JP2012/064040
(87) International publication number: WO 2012/169418

(57) **Abstract**

The present invention relates to a solar cell module which is characterized in that: a light-transmitting elastomer member and a solar cell element are arranged in a space between a panel of a transparent member upon which sunlight is incident and a panel of a thermally conductive member which is arranged on the side opposite to the sunlight incidence side in such a manner that the light-transmitting elastomer member is closer to the sunlight incidence side; and the solar cell element is pressed by the light-transmitting elastomer member toward the panel of a thermally conductive member so that the solar cell element is compression bonded thereto. This solar cell module is most suitable as a solar cell module that has excellent heat dissipation of a cell, the temperature of which is increased due to sunlight or a hot spot, and a structure that suppresses the production cost.

## Description

### TECHNICAL FIELD

This invention relates to a solar cell module and a method for manufacturing the same.

### BACKGROUND ART

When a solar cell module is installed outdoor, typically on a house or building roof, the temperature of the module is greatly elevated due to sunlight, particularly in summer. As the temperature of the solar cell module is elevated, the temperature of the solar cell assembly is also elevated. It is known that the power generation efficiency of the solar cell module is reduced by such temperature elevation. In the case of a single crystal silicon cell, for example, provided that the power generation efficiency at 25°C is 100%, the power generation efficiency is reduced by about 0.4% every time when the device temperature increases 1°C from 25°C. Therefore, how to dissipate heat from the solar cell assembly at elevated temperature is a key factor for efficient utilization of the module.

Further, the solar cell module for power generation does not always receive uniform sunlight. In fact, the module is sometimes partially shaded. Then, the shaded solar cell assembly provides insufficient power generation. As a result, reverse bias voltage is applied to the shaded solar cell assembly, giving rise to a heat-up phenomenon, known as "hot spot." If the "hot-spot" phenomenon continues, the temperature of that solar cell assembly continues increasing, leading to a failure at worst.

In the prior art, several means are proposed for preventing temperature elevation of the solar cell assembly. For example, the solar cell module is provided at the back side with a heat dissipating structure made of highly heat-conductive metal (see, for example, Patent Document 1: JP 2770906); a heat conducting block member is combined with a heat pipe for heat dissipation to the back side (see, for example, Patent Document 2: JP-A H09-186353); a laminate structure of heat-dissipating layers of metals having different coefficients of linear expansion is used for heat dissipation (see, for example, Patent Document 3: JP 4206265); a web of metal member is bonded to the back side of the solar cell module for heat dissipation (see, for example, Patent Document 4: JP-A 2006-156581). However, the use of metal materials has a possibility to increase the module manufacture cost because of the material and working expenses, and also causes difficulty of handling because of the increased weight of the overall module.

Meanwhile, the solar power generation panel system is most often a plate system in which solar cells based on silicon wafers of about 200 µm thick are closely arranged on the sunlight-receiving surface. However, since the solar cells which are arranged in proportion to the light-receiving area become expensive, it is difficult to reduce the cost of solar power generation panels. Under the circumstances, efforts are made to develop a concentrator solar cell module in which the light on the sunlight-receiving surface is condensed at a small-diameter solar cell by a collective lens. The concentrator solar cell module adapted for light collection can substantially reduce the number of solar cells used, as compared with the plate system. However, for the concentrator solar cell module adapted for light collection, biaxial tracking is necessary so that the sunlight-receiving surface may face toward sunlight. Further, the framework for tracking must be robust in consideration of the outdoor service environment. The investment including the framework installation expense offsets the original cost merit arising from a substantial saving of the number of expensive solar cells used.

On the other hand, some proposals are made for the concentrator solar cell module to which heat dissipation is critical, for example, a resin loaded with a metal additive is used to form a heat dissipating and electrically insulating layer having dielectric properties as well, which is bonded to an electrode plate below a solar cell for heat dissipation (see, for example, Patent Document 5: JP-A 2006-332535); and two layers of resins having different elasticity or viscosity are provided between a solar cell and a stationary back lining for heat dissipation (see, for example, Patent Document 6: JP-A 2007-165485).

Also in the prior art, ethylene-vinyl acetate (EVA) copolymers are generally used as the encapsulant for solar cell assemblies, and encapsulation is accomplished by the lamination step entailing reduced pressure, heat and the like. The step includes many cumbersome operations, and any failure in this step leads to a drop of solar cell performance. Thus, proposals are made for improving the manufacture yield, for example, wires covered with heat resistant film are used as the lead-out conductors from positive and negative electrodes positioned at opposite ends of the solar cell module for preventing any short-circuiting with other lead wires (see, for example, Patent Document 7: JP-A H09-326497); an integral multilayer film composed of two or more resins is used as at least one of front and back side coating materials of a photovoltaic device for encapsulation (see, for example, Patent Document 8: JP-A H11-087744).

However, the prior art methods are difficult to achieve efficient heat dissipation from the solar cell assembly at the elevated temperature, because of the strain induced by temperature rise due to a difference in coefficient of linear expansion between the solar cell and the heat dissipating material. In particular, for those solar cell assemblies fabricated using silicon wafers having a thickness of 200 µm or less, there is a risk that cracks form during the temperature rise, under the influence of the coefficient of linear expansion of the material in close contact with the solar cell assembly. It is also known that the EVA commonly used as the encapsulant largely changes its modulus with temperature changes (see, for example, Non-Patent Document 1: Barry Ketola, Keith R. McIntosh, Ann Norris, Mary Kay Tomalia, "Silicone for Photovoltaic Encapsulation": 23rd European Photovoltaic Solar Energy Conference 2008, pp. 2969-2973). The influence on the solar cell assembly is of concern.

Also for the purpose of reducing the manufacture cost of solar cell modules, it is required to reduce the cost of silicon wafers which accounts for at least 50% of the solar cell module cost. To this end, there is a demand for a solar cell assembly which has an economic advantage as a result of reducing the cell area and concurrently reducing the cell thickness to or below 120 µm. However, since the solar cell assembly manufactured from such a thin wafer is liable to damage by impact, it is difficult to use similar sealing and heat-dissipating materials in an equivalent manner, as compared with solar cell modules manufactured from wafers having a thickness in excess of 200 µm. In particular, the interconnections on the surface of the solar cell assembly undergo embrittlement in the outdoor environment with temperature changes, due to differences in coefficient of linear expansion and modulus of sealing materials on the front and back sides of the solar cell assembly, as pointed out in, for example, Non-Patent Document 2: D. L. King, M. A. Quintana, J. A. Kratochvil, D. E. Ellibee and B. R. Hansen, "Photovoltaic Module Performance and Durability Following Long Term Field Exposure, Progress in Photovoltaics: Research and Application 8 (2000) pp. 241-256; and Non-Patent Document 3: M. A. Quintana, D. L. King, T. J. MacMahon and C. R. Osterwald, "Commonly Observed Degradation in Field-Aged Photovoltaic Modules," Proceedings of the 29th IEEE Photovoltaic Specialists Conference, New Orleans, 2002, pp. 1392-1395.

With respect to the cost aspect, on the other hand, the prior art uses an adhesive for bonding a solar cell assembly and a heat-dissipating member together and use two resin layers for improving heat dissipation, which can cause cost increases. With respect to the adhesive, there is a concern that it undergoes embrittlement during service over 10 years in the outdoor environment with temperature changes, which can cause formation of foreign matter.

With respect to the manufacturing yield, the prior art must cover lead-out wires with film or use two or more resins to form an integral laminate film as the cover, which can cause cost increases. There is also a possibility of negating ease of re-working.

### SUMMARY OF INVENTION

### Technical Problem

An object of the invention is to provide a solar cell module having the advantages of excellent heat dissipation of each solar cell, ease of re-working, improved manufacturing yield, and reduced manufacturing cost; and a method for manufacturing the same.

### Solution to Problem

To attain the above object, the present invention provides a solar cell module which is structured such that a solar cell assembly is interposed in a space between a transparent member panel upon which sunlight is incident and a heat-conductive member panel which is arranged opposite to the sunlight incident side, and pressed in compression bond by a light-transmitting elastomer member having rubber elasticity for thereby relaxing the strain due to a difference in coefficient of linear expansion upon temperature changes, and the heat-conductive member has a sufficient area to ensure heat dissipation.

Specifically, the present invention provides a solar cell module and a method for manufacturing the same, as defined below.
[1] A solar cell module comprising a transparent member panel upon which sunlight is incident, a heat-conductive member panel which is arranged opposite to the sunlight incident side, a light-transmitting elastomer member and a solar cell assembly interposed in a space between the transparent member panel and the heat-conductive member panel, such that the light-transmitting elastomer member is disposed closer to the sunlight incident side, and the light-transmitting elastomer member presses the solar cell assembly toward the heat-conductive member panel in compression bond thereto.
[2] The solar cell module of [1], further comprising a heat-conductive elastomer layer interposed between the heat-conductive member panel and the solar cell assembly.
[3] The solar cell module of [2] wherein the heat-conductive elastomer layer is made of a heat-conductive silicone rubber having a thermal conductivity of 0.2 W/m·K to 5 W/m·K.
[4] The solar cell module of any one of [1] to [3], further comprising a spacer member disposed at the periphery of the space between the transparent member panel and the heat-conductive member panel.
[5] The solar cell module of any one of [1] to [4], further comprising a frame member spanned between the peripheral edges of the transparent member panel and the heat-conductive member panel for fixedly clamping the panels.
[6] The solar cell module of any one of [1] to [5], wherein the heat-conductive member panel is formed of a glass, synthetic resin or metal material, or composite thereof.
[7] The solar cell module of any one of [1] to [6], wherein the solar cell assembly is formed of a silicon material.
[8] The solar cell module of any one of [1] to [7], wherein the light-transmitting elastomer member is formed of a cured product of a silicone rubber composition.
[9] The solar cell module of any one of [1] to [8], wherein the light-transmitting elastomer member is an optical sheet for concentrator solar cells.
[10] A method for manufacturing a solar cell module, comprising the steps of laminating in order a light-transmitting elastomer member and a solar cell assembly onto a transparent member panel upon which sunlight is incident, and placing a heat-conductive member panel over the solar cell assembly such that the light-transmitting elastomer member presses the solar cell assembly toward the heat-conductive member panel in compression bond thereto.
[11] The method of [10], further comprising the step of placing a sealing member at the periphery of the transparent member panel and placing a spacer member inside the sealing member, such that the light-transmitting elastomer member and the solar cell assembly are disposed inside the spacer member, prior to the step of placing a heat-conductive member panel.
[12] The method of [10] or [11], wherein the step of placing a heat-conductive member panel over the solar cell assembly includes placing a heat-conductive elastomer over the solar cell assembly and placing a heat-conductive member panel thereon.
[13] The method of any one of [10] to [12], further comprising the step of spanning a frame member between the peripheral edges of the transparent member panel and the heat-conductive member panel for fixedly clamping the panels.

### Advantageous Effects of Invention

The solar cell module of the invention allows for effective heat dissipation of a cell which has elevated its temperature due to sunlight or a hot spot, and is best suited because of the structure capable of suppressing the manufacturing cost.

An improvement in manufacturing yield is expectable because the invention eliminates a need for encapsulation of a solar cell assembly by cumbersome lamination step. Since the solar cell assembly is pressed into compression bond solely by elastomer, it is easily re-workable.

### BRIEF DESCRIPTION OF DRAWINGS

FIG. 1 is a partially cut-away, cross-sectional view of a solar cell module in one embodiment of the invention.
FIG. 2 is a partially cut-away, cross-sectional view of a solar cell module in another embodiment of the invention using an optical sheet for concentrator solar cells.

### DESCRIPTION OF EMBODIMENTS

Now, referring to the drawings, some embodiments of the solar cell module of the invention are described.

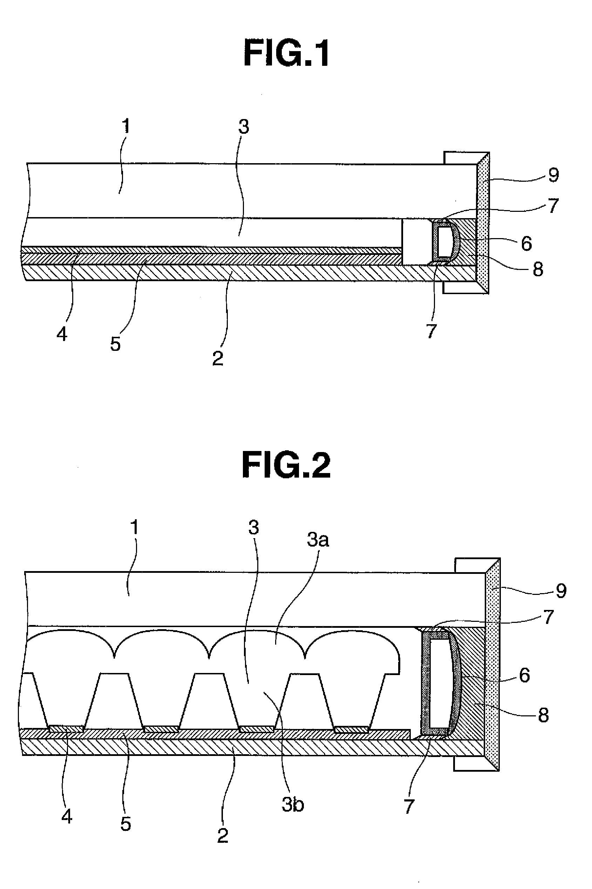

FIG. 1 illustrates one exemplary solar cell module using a plate-like sheet as the light-transmitting elastomer member. FIG. 2 illustrates another exemplary solar cell module using an optical sheet for concentrator solar cells as the light-transmitting elastomer member.

In FIGS. 1 and 2, there are provided a transparent member panel 1 upon which sunlight is incident, and a heat-conductive member panel 2 which is arranged opposite to the sunlight incident side. A light-transmitting elastomer member 3 and a solar cell assembly 4 comprising a semiconductor substrate are interposed in a space between the panels 1 and 2, such that the light-transmitting elastomer member 3 is disposed closer to the sunlight incident side, and the light-transmitting elastomer member 3 presses the solar cell assembly 4 toward the heat-conductive member panel 2 in compression bond thereto.

In the embodiments of FIGS. 1 and 2, a heat-conductive elastomer layer 5 is interposed between the solar cell assembly 4 and the heat-conductive member panel 2. The solar cell assembly 4 is brought in compression bond to the heat-conductive member panel 2 via the heat-conductive elastomer layer 5.

Further, in the embodiment of FIG. 1, the solar cell assembly 4 includes an array of solar cells arranged continuously without gaps therebetween, and the light-transmitting elastomer member 3 is formed as a plate-like sheet.. On the other hand, in the embodiment of FIG. 2, the solar cell assembly 4 includes an array of solar cells spaced apart at certain intervals, and the light-transmitting elastomer member 3 is formed as an optical sheet for concentrator solar cells. The light-transmitting elastomer member 3 consists of heads 3a of semi-spherical shape and columns 3b of inverted frustoconical shape integrally coupled thereto and presses at the bottom of columns 3b the solar cell assembly 4 (solar cells).

A spacer member 6 is disposed near the periphery of the space between the panels 1 and 2. Sealing members 7 and 7 are disposed between the top and bottom of the spacer member 6 and the panels 1 and 2, respectively, and a sealing member 8 is disposed at the periphery of the space outside the spacer member 6. Thus the light-transmitting elastomer member 3, solar cell assembly 4, and heat-conductive elastomer layer 5 are sealed within the space. A frame member 9 of U-shape in cross section is spanned between the outer edges of the panels 1 and 2 to fixedly clamp the panels 1 and 2.

Described below is the preferred method of manufacturing such a solar cell module. A panel 1 of transparent member such as colorless tempered glass upon which sunlight is incident is provided, and a sealing member 8 of butyl rubber or the like is placed on the surface of the panel 1 opposite to the light-incident surface and inside its outer periphery like a frame. Then a spacer member 6 of aluminum alloy or the like is placed along and inside the sealing member 8 placed in a frame pattern. At this point, a sealing member 7 of silicone rubber or the like is placed between the spacer member 6 and the colorless tempered glass plate 1 on the light-incident side. Next, a light-transmitting elastomer member 3 and a solar cell assembly 4 are disposed inside the spacer member 8 so that the light-transmitting elastomer member 3 is in contact with the panel 1. Further, a heat-conductive elastomer layer 5 is disposed in contact with the solar cell assembly 4, after which a panel 2 of heat-conductive member is placed on the side of the heat-conductive elastomer layer 5 remote from the light-incident side. At this point, a sealing member 7 of silicone rubber or the like is interposed between the spacer member 6 and the panel 2, and the panel 2 is joined so as to sandwich the spacer member 6 and the sealing member 8 of butyl rubber. To avoid moisture entrapment and to improve the sealing performance of the sealing member 8 of butyl rubber or the like, the panel 2 is preferably joined by using a vacuum laminator and heating at 100 to 150°C in a vacuum of 100 to 130 Pa. Finally, the panel 1 on the light-incident side and the panel 2 on the opposite side are clamped together by a U-shaped frame member 9 of aluminum alloy or the like so that the predetermined pressure may be applied to the solar cell assembly 4, completing the solar cell module.

As the transparent member panel 1, a member having long-term reliable properties on outdoor use including transparency, weather resistance and impact resistance is necessary. While members, for example, of colorless tempered glass, acrylic resin, fluoro-resin and polycarbonate resin are useful, colorless tempered glass having a thickness of about 3 to 5 mm is widely used.

Next, the heat-conductive member panel 2 is required to be capable of efficient heat dissipation to reduce the temperature of the solar cell assembly. It is made of a material such as glass, synthetic resin or a composite thereof. Examples of the glass include soda-lime glass, colorless glass and tempered glass; suitable synthetic resins include acrylic resin, polycarbonate (PC) resin, polyethylene terephthalate (PET) resin and epoxy resin. Suitable metal materials include copper, aluminum, iron and the like. Suitable composite materials include synthetic resins loaded with highly heat-conductive materials such as silica, titanium oxide, alumina and aluminum nitride.

It is noted that if transparent members are used as the heat-conductive member panel 2 and the heat-conductive elastomer layer 5, then directly reaching light of sunlight and a portion of scattering light can be transmitted to the side remote from the sunlight-incident side. In an example where the solar cell module is installed in a grassland, part of sunlight reaches the area of the land which is on the side of the solar cell module remote from the incident side, that is, shaded by the module, promoting growth of plants and enabling utilization of the land for pasturage.

Also, the solar cell assembly 4 is constructed using one or two silicon materials selected from monocrystalline silicon and polycrystalline silicon. It is noted that since the solar cell assembly used in the solar cell module using a concentrator solar cell optical sheet as illustrated in FIG. 2 is adapted for condensation of sunlight, the area of the device can be reduced to 1/2 to 1/3 of the area of the solar cell assembly illustrated in FIG. 1.

Reference is now made to the light-transmitting elastomer member 3. Since this member must have long-term reliable properties over 20 years on outdoor use including transparency and weather resistance, it is preferable to use a sheet obtained by curing a millable type silicone rubber composition which is heavily loaded with fumed silica so that the composition may have high UV resistance and be compatible with heat compression molding, and extrusion molding or calendering suited as the working method for efficient mass-production of concentrator optical sheets.

The sheet is obtained by curing a silicone rubber composition, for example, a silicone rubber composition comprising:
(A) 100 parts by weight of an organopolysiloxane containing at least two aliphatic unsaturated groups per molecule and having a degree of polymerization of at least 100, represented by the average compositional formula (I):

   R¹ₐSiO_{(4-a)/2} (I)

   wherein R¹ is each independently a substituted or unsubstituted monovalent hydrocarbon group, and a is a positive number of 1.95 to 2.05,
(B) 70 to 150 parts by weight of fumed silica having a specific surface area of more than 200 m²/g,
(C) 0.1 to 30 parts by weight of an organohydrogenpolysiloxane containing at least two silicon-bonded hydrogen atoms per molecule, and
(D) a hydrosilylation catalyst in an amount of 0.5 to 1,000 ppm based on the weight of component (A).

This silicone rubber composition is a millable type material which can be worked by extrusion molding, calendering or the like. Its cured product exhibits high transparency despite silica loading and is best suited as the concentrator optical sheet.

Component (A) is an organopolysiloxane having a degree of polymerization of at least 100, represented by the average compositional formula (I). In average compositional formula (I), R¹ which is the same or different is a substituted or unsubstituted monovalent hydrocarbon group, typically having 1 to 12 carbon atoms, preferably 1 to 8 carbon atoms, for example, alkyl groups such as methyl, ethyl, propyl, butyl, hexyl, and octyl, cycloalkyl groups such as cyclopentyl and cyclohexyl, alkenyl and cycloalkenyl groups such as vinyl, allyl and propenyl, aryl groups such as phenyl and tolyl, aralkyl groups such as benzyl and 2-phenylethyl, or substituted forms of the foregoing in which some or all hydrogen atoms are substituted by halogen atoms, cyano or the like. Inter alia, methyl, vinyl, phenyl and trifluoropropyl are preferred, with methyl and vinyl being most preferred.

Preferred examples of component (A) include organopolysiloxanes whose backbone consists of recurring dimethylsiloxane units, and those backbone-forming dimethylpolysiloxane structures consisting of recurring dimethylsiloxane units having partially incorporated therein units having a phenyl, vinyl or 3,3,3-trifluoropropyl group such as diphenylsiloxane units, methylphenylsiloxane units, methylvinylsiloxane units or methyl-3,3,3-trifluoropropylsiloxane units.

In particular, the organopolysiloxane should preferably have per molecule at least two aliphatic unsaturated groups such as alkenyl or cycloalkenyl groups, of which vinyl is most preferred. It is preferred that the aliphatic unsaturated group account for 0.01 to 20 mol%, especially 0.02 to 10 mol% of the entire R¹. It is noted that the aliphatic unsaturated group may be attached to a silicon atom at the end of the molecular chain or a silicon atom midway the molecular chain or both. It is preferred that the aliphatic unsaturated group may be attached to at least a silicon atom at the end of the molecular chain. The subscript "a" is a positive number of 1.95 to 2.05, preferably 1.98 to 2.02, and more preferably 1.99 to 2.01.

More preferably, the organopolysiloxane as component (A) is of average compositional formula (I) wherein R¹ is a monovalent hydrocarbon group of 1 to 6 carbon atoms and at least two groups per molecule are alkenyl groups.

Preferred examples of the organopolysiloxane as component (A) include those capped at the end of the molecular chain with a triorganosiloxy group such as trimethylsiloxy, dimethylphenylsiloxy, dimethylhydroxysiloxy, dimethylvinylsiloxy, methyldivinylsiloxy or trivinylsiloxy.

Of these, methylvinylpolysiloxane, methylphenylvinylpolysiloxane, and methyltrifluoropropylvinylpolysiloxane are most preferred.

The organopolysiloxane may be obtained, for example, from (co)hydrolytic condensation of one or more organohalogenosilanes, or from ring-opening polymerization of a cyclic polysiloxane (e.g., siloxane trimer or tetramer) in the presence of a basic or acidic catalyst. It is basically a linear diorganopolysiloxane although a mixture of two, three or more organopolysiloxanes having different molecular weight (degree of polymerization) or molecular structure is also acceptable as component (A).

The organopolysiloxane has a degree of polymerization of at least 100, preferably 100 to 100,000, and more preferably 3,000 to 20,000. Notably, the degree of polymerization may be measured as a weight average degree of polymerization by gel permeation chromatography (GPC) versus polystyrene standards.

Component (B) is reinforcing silica having a BET specific surface area of more than 200 m²/g. This reinforcing silica is added to formulate a silicone rubber composition having high transparency and good mechanical strength. To improve the transparency of a silicone rubber composition, the BET specific surface area should exceed 200 m²/g and preferably be at least 250 m²/g. If the BET specific surface area is equal to or less than 200 m²/g, the cured composition becomes less transparent. Although the upper limit of BET specific surface area is not critical, the surface area is typically up to 500 m²/g, and preferably up to 400 m²/g from the standpoint of working efficiency or the like.

Although examples of silica commonly used in the silicone rubber composition include fumed silica, precipitated silica and the like, fumed silica is used herein because precipitated silica, if used, causes a lowering of transparency. Also silica which has been surface treated with a chlorosilane, alkoxysilane, hexamethyldisilazane or the like to be hydrophobic is preferably used. Inter alia, treatment with hexamethyldisilazane is preferred because of higher transparency.

The amount of reinforcing silica added as component (B) is preferably 70 to 150 parts, more preferably 70 to 120 parts by weight per 100 parts by weight of the organopolysiloxane as component (A). If the amount of silica is less than 70 parts, a sheet obtained by curing a silicone rubber compound loses transparency. More than 150 parts of silica is difficult to disperse in the silicone polymer.

Component (C) is an organohydrogenpolysiloxane containing at least two silicon-bonded hydrogen atoms per molecule. This organohydrogenpolysiloxane contains at least two silicon-bonded hydrogen atoms (i.e., SiH groups) in the molecule. Any prior art well-known organohydrogenpolysiloxane is applicable herein, preferably represented by the average compositional formula (II):

R²_{b}H_{c}SiO_{(4-b-c)/2} (II)

wherein R² is a substituted or unsubstituted, monovalent hydrocarbon group of 1 to 6 carbon atoms, b is a number of 0.7 to 2.1, c is a number of 0.18 to 1.0, and b+c is 0.8 to 3.0.

R² is a substituted or unsubstituted, monovalent hydrocarbon group of 1 to 6 carbon atoms, preferably free of aliphatic unsaturation. Examples include unsubstituted monovalent hydrocarbon groups such as alkyl groups, e.g., methyl, ethyl, propyl, butyl, pentyl and hexyl, cyclohexyl, cyclohexenyl and phenyl and substituted forms of the foregoing monovalent hydrocarbon groups in which at least one hydrogen atom is substituted by a halogen atom or cyano group, typically substituted alkyl groups, such as 3,3,3-trifluoropropyl and cyanomethyl.

With respect to b and c, preferably, b is 0.8 to 2.0, c is 0.2 to 1.0, and b+c is 1.0 to 2.5.

The organohydrogenpolysiloxane as component (C) has a molecular structure which may be linear, cyclic, branched or three-dimensional network. Preference is given to an organohydrogenpolysiloxane in which the number of silicon atoms per molecule (or degree of polymerization) is 2 to about 300, especially 4 to about 200 and which is liquid at room temperature. While the silicon-bonded hydrogen atom (SiH group) may be positioned at the end or side chain of the molecular chain or both, an organohydrogenpolysiloxane containing at least two (specifically 2 to 300), preferably at least three (specifically 3 to 200), and more preferably 4 to 150 SiH groups per molecule is used.

Examples of the organohydrogenpolysiloxane as component (C) include 1,1,3,3-tetramethyldisiloxane, 1,3,5,7-tetramethylcyclotetrasiloxane, methylhydrogencyclopolysiloxane, methylhydrogensiloxane/dimethylsiloxane cyclic copolymers, tris(dimethylhydrogensiloxy)methylsilane, tris(dimethylhydrogensiloxy)phenylsilane, both end trimethylsiloxy-capped methylhydrogenpolysiloxane, both end trimethylsiloxy-capped dimethylsiloxane/methylhydrogensiloxane copolymers, both end dimethylhydrogensiloxy-capped dimethylpolysiloxane, both end dimethylhydrogensiloxy-capped dimethylsiloxane/methylhydrogensiloxane copolymers, both end trimethylsiloxy-capped methylhydrogensiloxane/diphenylsiloxane copolymers, both end trimethylsiloxy-capped methylhydrogensiloxane/diphenylsiloxane/dimethylsiloxane copolymers, cyclic methylhydrogenpolysiloxane, cyclic methylhydrogensiloxane/dimethylsiloxane copolymers, cyclic methylhydrogensiloxane/diphenylsiloxane/dimethylsiloxane copolymers, copolymers consisting of (CH₃)₂HSiO_{1/2} units and SiO_{4/2} units, and copolymers consisting of (CH₃)₂HSiO_{1/2} units, SiO_{4/2} units, and (C₆H₅)SiO_{3/2} units, as well as substituted forms of the foregoing in which some or all methyl groups are substituted by other alkyl groups such as ethyl or propyl, or aryl groups such as phenyl.

The amount of organohydrogenpolysiloxane added as component (C) is 0.1 to 30 parts, more preferably 0.1 to 10 parts, and even more preferably 0.3 to 10 parts by weight per 100 parts by weight of the organopolysiloxane as component (A).

Also, the organohydrogenpolysiloxane added as component (C) is preferably blended in such amounts that the molar ratio of silicon-bonded hydrogen atoms (i.e., SiH groups) in component (C) to silicon-bonded alkenyl groups in component (A) may be from 0.5 to 5 mol/mol, more preferably from 0.8 to 4 mol/mol, and even more preferably from 1 to 3 mol/mol.

The hydrosilylation reaction catalyst as component (D) may be any of well-known catalysts, for example, platinum-based catalysts such as platinum black, platinic chloride, chloroplatinic acid, reaction products of chloroplatinic acid with monohydric alcohols, complexes of chloroplatinic acid with olefins, and platinum bisacetoacetate, palladium-based catalysts, and rhodium-based catalysts.

The hydrosilylation catalyst as component (D) may be used in a catalytic amount, which is typically of the order of 0.5 to 1,000 ppm, preferably 1 to 200 ppm of platinum group metal based on the weight of component (A).

To the silicone rubber composition comprising at least components (A) to (D), flame retardants, coloring agents and other additives may be added insofar as the objects of the invention are not impaired.

The silicone rubber composition may be obtained by milling predetermined amounts of the foregoing components on a two-roll mill, kneader, Banbury mixer or the like. When the silicone rubber composition is shaped, a suitable shaping technique such as press molding, extrusion molding or calendering (but is not limited thereto) may be used.

The conditions for curing the silicone rubber composition are not particularly limited. Generally, the composition is heat cured at a temperature of 80 to 300°C, especially 100 to 250°C for a time of 5 seconds to 1 hour, especially 30 seconds to 30 minutes, thereby obtaining keypads or the like. Further it may be post-cured at 100 to 200°C for 10 minutes to 10 hours.

The cured product of the silicone rubber composition is preferably such that a cured sheet of 2 mm thick has a total light transmittance of at least 90% in a wavelength range of 0.35 to 1.15 µm which corresponds to the spectral sensitivity region of crystalline silicon. Specifically, the transmittance is at least 90% as measured by a direct reading haze computer HGM-2 (Suga Test Instrument Co., Ltd.). If the total light transmittance is less than 90%, the incident light may not reach the deepest point of the optical sheet due to excessive light diffusion. The cured product of the silicone rubber composition is preferably such that a cured sheet of 2 mm thick has a haze of up to 10%, especially up to 8%, as measured by a direct reading haze computer HGM-2 (Suga Test Instrument Co., Ltd.). If the haze exceeds 10%, the incident light may not reach the deepest point of the light-transmitting elastomer member due to excessive light diffusion.

Described below is an embodiment wherein the optical sheet for concentrator solar cells is a sheet obtained by curing a silicone rubber composition (in sheet form of 2 mm thick) having a transmittance of at least 90% at a wavelength of 0.35 to 1.15 µm. In the case of concentrator solar cells, it must be taken into account for effectively taking up direct sunlight that the southing height changes seasonally. Thus the shape of the concentrator optical sheet used in the solar cell module of the invention is configured in uniaxial direction.

It must be taken into account that the southing height undergoes a change of +23 degrees at the summer solstice and -23 degrees at the winter solstice with respect to the original points of vernal equinox and autumnal equinox. Using a geometrical optical software (Light Tools), it has been confirmed that the shape of the concentrator optical sheet used in the solar cell module as shown in FIG. 2 ensures that when light is incident at an oblique angle of 23 degrees, the light on the output side of the sheet is incident substantially on the light-receiving surface of the solar cell. It has also been confirmed for the optical sheet that the total incident area of sunlight and the total incident area to solar cells are in a ratio of 2.7:1.0. Thus, the tracking system for facing the light-receiving surface toward the sun is not essential in the practice of the invention. A single linear optical sheet having a shape of repeating simple linear structures according to the invention accomplishes 2.7 times concentration. The invention provides a solar cell module having a degree of concentration of more than 2 times with respect to direct light having a deviation of ±23 degrees relative to the southing height.

Next, the frame member 9 is preferably made of aluminum alloy, stainless steel or similar material having satisfactory strength against impact, wind pressure or snow, weather resistance, and light weight. The frame member 9 molded from such material is mounted so as to surround the outer periphery of the sandwich structure between panels 1 and 2 and fixedly secured thereto by screws.

In the solar cell module of the invention, the light-transmitting elastomer member 3 having rubber elasticity presses the solar cell assembly in compression bond. At this point, the pressing pressure is preferably in a range of 0.01 MPa to 5.0 MPa, and more preferably 0.05 MPa to 2.0 MPa. If the pressing pressure is less than 0.01 MPa, there is a possibility that the solar cell assembly will not be secured in place, some of incident sunlight will not be taken in the solar cell assembly, or the elevated temperature of the solar cell assembly will not be lowered via heat dissipation from the back side of the assembly. Inversely, if the pressing pressure exceeds 5.0 MPa, there is a possibility that the strain introduced by a difference in coefficient of linear expansion with temperature changes will not be relaxed, or on use of the concentrator optical sheet shown in FIG. 2, the optical sheet made of light-transmitting elastomer will be deformed whereby the concentration function will be degraded. There is also a possibility that the solar cell assembly will be broken, particularly when the assembly has a thickness of up to 120 µm.

In the solar cell module of the invention, the outer edge portions of the transparent member panel 1 upon which sunlight is incident and the heat-conductive member panel 2 disposed opposite to the sunlight incident side may be held together via the spacer member 6. The spacer member 6 is required to have functions of keeping constant the distance between the sunlight-incident transparent member panel 1 and the heat-conductive member panel 2, and controlling the pressure under which the light-transmitting elastomer member 3 having rubber elasticity presses the solar cell assembly 4. Suitable materials include metals such as aluminum and rigid resins. Notably, silicone rubber or butyl rubber may be used for bonding the spacer member to the panels.

In the solar cell module of the invention, the heat-conductive elastomer layer 5 may be provided between the heat-conductive member panel 2 and the solar cell assembly 4. It may be placed as a sheet or formed as a coating layer. The provision of the heat-conductive elastomer layer 5 is effective for relaxing and absorbing the strain induced by a difference in coefficient of linear expansion between the heat-conductive member panel 2 and the solar cell assembly 4, or for enhancing the adhesion to the heat-conductive member panel 2 for effective dissipation of generated heat.

The heat-conductive elastomer layer 5 is preferably a cured silicone rubber having a thermal conductivity of 0.2 W/m·K to 5 W/m·K, especially 0.5 W/m·K to 5 W/m·K (ASTM E-1530). If the thermal conductivity is less than 0.2 W/m·K, it may become necessary to increase the temperature for achieving heat compression bond between the heat-conductive member panel 2 and the solar cell assembly 4 or to prolong the compression bond time, which is disadvantageous in efficiency. If the thermal conductivity exceeds 5 W/m·K, the heat-conductive elastomer layer becomes so hard that it is difficult to work into a sheet form and also difficult to achieve uniform compression bond to the solar cell assembly.

The heat-conductive elastomer layer 5 preferably has a thickness of 200 µm to 700 µm, more preferably 300 µm to 500 µm. If the thickness is less than 200 µm, heat transfer from the solar cell assembly to the heat-conductive elastomer layer may not rapidly take place, failing to suppress the temperature elevation of the solar cell assembly. If the thickness exceeds 700 µm, heat transfer from the heat-conductive elastomer layer to the heat-conductive member may not rapidly take place.

The heat-conductive elastomer layer 5 is formed of a composition comprising 100 parts by weight of an organopolysiloxane and 10 to 1,600 parts by weight of at least one agent selected from among carbon, metals, metal oxides, metal nitrides, and metal carbides, added thereto. Exemplary agents include metals such as silver powder, copper powder, iron powder, nickel powder, and aluminum powder, metal oxides such as zinc, magnesium, aluminum, silicon and iron oxides, metal nitrides such as boron, aluminum, and silicon nitrides, and metal carbides such as silicon and boron carbides.

Optionally, various additives may be added to the heat-conductive elastomer composition, for example, coloring pigments, heat resistance improvers, flame retardants, and acid acceptors, as well as dispersants such as various alkoxysilanes, diphenylsilane diol, carbon functional silanes, and silanol-containing siloxanes.

The heat-conductive elastomer composition is obtainable by mixing the foregoing components on a mixer such as two-roll mill, Banbury mixer, kneader, or planetary mixer until uniform, and optionally heat treating at a temperature of at least 100°C.

When the heat-conductive elastomer composition is cured into a rubber elastomer, a curing agent is used which may be selected from prior art well-known agents commonly used in the curing of silicone rubber compositions. Exemplary curing agents include organic peroxides used in radical reaction such as di-t-butylperoxide, 2,5-dimethyl-2,5-di(t-butylperoxy)-hexane, and dicumyl peroxide; addition reaction curing agents for organopolysiloxanes having alkenyl groups, such as a combination of an organohydrogenpolysiloxane containing at least two silicon-bonded hydrogen atoms per molecule and a platinum group metal-based catalyst; and condensation reaction curing agents for organopolysiloxanes having silanol groups, such as an organic silicon compound having at least two hydrolyzable groups such as alkoxy, acetoxy, ketoxime or propenoxy groups. The amount of the curing agent added may be the same as used in conventional silicone rubber compositions.

The heat-conductive elastomer composition used herein may be either a millable type silicone rubber composition or a liquid type silicone rubber composition. From the aspects of working and shaping, preference is given to a heat-conductive silicone rubber composition of the organic peroxide cure or addition reaction cure type.

Preferably, the heat-conductive elastomer layer is formed by curing the heat-conductive elastomer composition.

### EXAMPLES

Examples, Reference Examples and Comparative Examples are shown below for illustrating the invention although the invention is not limited to the Examples.

### [Reference Example 1]

### Preparation of light-transmitting elastomer member

A compound was prepared by combining 100 parts by weight of an organopolysiloxane consisting of 99.475 mol% dimethylsiloxane units, 0.50 mol% methylvinylsiloxane units, and 0.025 mol% dimethylvinylsiloxane units and having an average degree of polymerization of about 6,000 with 70 parts by weight of silica having a BET specific surface area of 300 m²/g (trade name Aerosil 300 by Nippon Aerosil Co., Ltd.), 16 parts by weight of hexamethyldisilazane as dispersant, and 4 parts by weight of water, kneading on a kneader, and heat treating at 170°C for 2 hours.

On a two-roll mill, 0.5 parts by weight of C-25A (platinum catalyst) and 2.0 parts by weight of C-25B (organohydrogenpolysiloxane), both available from Shin-Etsu Chemical Co., Ltd., were kneaded and added as addition crosslinking/curing agent to 100 parts by weight of the compound, followed by uniform mixing. The resulting composition was press cured at 120°C and 70 kgf/cm² for 10 minutes and post-cured at 200°C for 4 hours to form a test sheet having a thickness of 2 mm.

### [Example 1]

### Preparation of solar cell module #1

A solar cell module was manufactured using the light-transmitting elastomer member molded in Reference Example 1. Specifically, a colorless tempered glass plate of 3.2 mm thick was provided on the light incident side, and a web of butyl rubber as sealing member was extended on the surface of the glass plate opposite to the light-incident surface and inside its outer periphery like a frame. Then a spacer member of aluminum alloy was placed along and inside the sealing member of butyl rubber arranged in a frame pattern. At this point, a sealing member of silicone rubber was placed between the spacer member and the colorless tempered glass plate on the light-incident side. Next, the light-transmitting elastomer member (prepared above) and a solar cell assembly were disposed inside the spacer member so that the light-transmitting elastomer member was in contact with the colorless tempered glass plate. Further, a heat-dissipating silicone sheet TC-20A (thickness 0.2 mm, thermal conductivity 1.1 W/m·K, Shin-Etsu Chemical Co., Ltd.) as the heat-conductive elastomer was disposed in contact with the side of the solar cell assembly remote from the light-incident side. Thereafter, another colorless tempered glass plate separate from the above colorless tempered glass plate was placed on the side of the heat-conductive elastomer remote from the light-incident side. At this point, a sealing member of silicone rubber was interposed between the spacer member and the other colorless tempered glass plate, and the glass plate was joined so as to sandwich the spacer member and the sealing member of butyl rubber. To avoid moisture entrapment and to improve the sealing performance of the sealing member of butyl rubber, the glass plate was joined by using a vacuum laminator and heating at about 120°C in a vacuum of 110 Pa. Finally, the colorless tempered glass plates on the light-incident side and on the opposite side were clamped together by a U-shaped frame member of aluminum alloy so that a pressure of about 0.5 MPa might be applied to the solar cell assembly, completing the solar cell module #1. It is noted that since this resulted in a structure wherein both the sunlight-incident side and the opposite side were provided by glass plates, electrodes were extended from between both the glass plates to form a circuit, as in the bifacial light-receiving module using a double-side glass plate structure.

### [Example 2]

### Preparation of solar cell module #2

A solar cell module #2 was manufactured as in Example 1 aside from using a heat-dissipating silicone sheet TC-45A (thickness 0.45 mm, thermal conductivity 1.1 W/m·K, Shin-Etsu Chemical Co., Ltd.) as the heat-conductive elastomer.

### [Example 3]

### Preparation of solar cell module #3

A solar cell module #3 was manufactured as in Example 1 aside from using a heat-dissipating silicone sheet TC-45BG (thickness 0.45 mm, thermal conductivity 5.0 W/m·K, Shin-Etsu Chemical Co., Ltd.) as the heat-conductive elastomer.

The adhesion of the heat-conductive elastomer to the solar cell assembly and the dissipation of heat generated in the solar cell assembly were tested in Examples 1 to 3, with the results shown in Table 1.

**Table 1**

| | Example 1 | Example 2 | Example 3 |
|---|---|---|---|
| Solar cell module | #1 | #2 | #3 |
| Thermal conductivity (W/m·K) | 1.1 | 1.1 | 5.0 |
| Heat-conductive sheet thickness (mm) | 0.2 | 0.45 | 0.45 |
| Pressing pressure (MPa) | 0.5 | 0.5 | 0.5 |
| Adhesion¹⁾ | ○ | ⊚ | ○ |
| Heat dissipation¹⁾ | ○ | ⊚ | ○ |

| | | | |
|---|---|---|---|
| 1) index for evaluation of adhesion and heat dissipation ⊚: excellent ○: good Δ: poor ×: extremely poor | | | |

### Reference Signs List

- 1: transparent member panel
- 2: heat-conductive member panel
- 3: light-transmitting elastomer member
- 3a: semi-spherical head
- 3b: inverted frustoconical column
- 4: solar cell assembly
- 5: heat-conductive elastomer layer
- 6: spacer member
- 7: sealing member
- 8: sealing member
- 9: frame member

## Claims

1. A solar cell module comprising
a transparent member panel upon which sunlight is incident,
a heat-conductive member panel which is arranged opposite to the sunlight incident side,
a light-transmitting elastomer member and a solar cell assembly interposed in a space between the transparent member panel and the heat-conductive member panel, such that the light-transmitting elastomer member is disposed closer to the sunlight incident side, and the light-transmitting elastomer member presses the solar cell assembly toward the heat-conductive member panel in compression bond thereto.

2. The solar cell module of claim 1, further comprising a heat-conductive elastomer layer interposed between the heat-conductive member panel and the solar cell assembly.

3. The solar cell module of claim 2 wherein the heat-conductive elastomer layer is made of a heat-conductive silicone rubber having a thermal conductivity of 0.2 W/m·K to 5 W/m·K.

4. The solar cell module of any one of claims 1 to 3, further comprising a spacer member disposed at the periphery of the space between the transparent member panel and the heat-conductive member panel.

5. The solar cell module of any one of claims 1 to 4, further comprising a frame member spanned between the peripheral edges of the transparent member panel and the heat-conductive member panel for fixedly clamping the panels.

6. The solar cell module of any one of claims 1 to 5, wherein the heat-conductive member panel is formed of a glass, synthetic resin or metal material, or composite thereof.

7. The solar cell module of any one of claims 1 to 6, wherein the solar cell assembly is formed of a silicon material.

8. The solar cell module of any one of claims 1 to 7, wherein the light-transmitting elastomer member is formed of a cured product of a silicone rubber composition.

9. The solar cell module of any one of claims 1 to 8, wherein the light-transmitting elastomer member is an optical sheet for concentrator solar cells.

10. A method for manufacturing a solar cell module, comprising the steps of:
laminating in order a light-transmitting elastomer member and a solar cell assembly onto a transparent member panel upon which sunlight is incident, and
placing a heat-conductive member panel over the solar cell assembly such that the light-transmitting elastomer member presses the solar cell assembly toward the heat-conductive member panel in compression bond thereto.

11. The method of claim 10, further comprising the step of placing a sealing member at the periphery of the transparent member panel and placing a spacer member inside the sealing member, such that the light-transmitting elastomer member and the solar cell assembly are disposed inside the spacer member, prior to the step of placing a heat-conductive member panel.

12. The method of claim 10 or 11, wherein the step of placing a heat-conductive member panel over the solar cell assembly includes placing a heat-conductive elastomer over the solar cell assembly and placing a heat-conductive member panel thereon.

13. The method of any one of claims 10 to 12, further comprising the step of spanning a frame member between the peripheral edges of the transparent member panel and the heat-conductive member panel for fixedly clamping the panels.
